(19) Europäisches Patentamt
European Patent Office
Office européen des brevets

(11) **EP 3 346 867 B1**

(12) **EUROPÄISCHE PATENTSCHRIFT**

(45) Veröffentlichungstag und Bekanntmachung des Hinweises auf die Patenterteilung:
**03.11.2021   Patentblatt 2021/44**

(21) Anmeldenummer: **16766241.0**

(22) Anmeldetag: **31.08.2016**

(51) Int Cl.:
*A44C 15/00* *(2006.01)*       *A44C 17/00* *(2006.01)*

(86) Internationale Anmeldenummer:
**PCT/EP2016/070507**

(87) Internationale Veröffentlichungsnummer:
**WO 2017/042075 (16.03.2017 Gazette 2017/11)**

(54) **FARBLICH VERÄNDERBARE SCHMUCKSTEINE**

VARIABLE COLOUR ORNAMENTAL STONES

PIERRE DÉCORATIVE Á COULEUR MODIFIABLE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **09.09.2015   EP 15184408**

(43) Veröffentlichungstag der Anmeldung:
**18.07.2018   Patentblatt 2018/29**

(73) Patentinhaber: **D. Swarovski KG**
**6114 Wattens (AT)**

(72) Erfinder:
• **BRUNTHALER, Michael**
**6071 Aldrans (AT)**
• **LEXER, Franz**
**6094 Axams (AT)**
• **MAIR, Mathias**
**6171 Völs (AT)**
• **ALTENBERGER, Ernst**
**6114 Kolsass (AT)**

(74) Vertreter: **Weal, Emily Teresa et al**
**Keltie LLP**
**No.1 London Bridge**
**London SE1 9BA (GB)**

(56) Entgegenhaltungen:
**WO-A2-2006/136587       FR-A- 1 221 561**
**GB-A- 798 080**

**Beschreibung**

**Gebiet der Erfindung**

Die Erfindung betrifft ein dekoratives Schmuckelement, welches einen transparenten Schmuckstein, eine wellenlängenselektive Schicht und eine farblich veränderbare Auflagefläche enthält und damit durch Farbänderungen ästhetische Effekte hervorrufen kann.

**Stand der Technik**

Die Farbgestaltung von dekorativen Schmucksteinen erfolgt üblicherweise durch die Verwendung von eingefärbten Schmucksteinen. Es ist aber auch bekannt, dass sich bei transparenten Schmucksteinen in Verbindung mit einem farblichen Untergrund die farbliche Wirkung des Schmucksteines ändert. Das durch das transparente Material gebrochene Licht und die Farbe des Untergrundes überlagern sich dabei. Ist die Farbe des Untergrundes veränderbar, lässt sich die farbliche Wirkung des Schmucksteines variieren.

Die Erzielung von ästhetischen Effekten wird auch in funktionellen Bereichen wichtiger. Beispielsweise ist Wearable-Technology ein Anwendungsgebiet für ästhetische Effekte. Insbesondere ist eine Farbänderung verbunden mit einem brillanten Erscheinungsbild (vide infra) wünschenswert. Aus der EP 1 086 269 B1 ist bekannt, dass durch die Farbe eines textilen Untergrundes in Verbindung mit darauf aufgebrachten Glaselementen eine veränderte optische Wirkung der Glaselemente eintritt. Es ist nicht Gegenstand der EP 1 086 269 B1, brillante Schmucksteine zur Verfügung zu stellen. In der US 2012/01133676 A1 ist ein reflektives Display beschrieben, welches aus einem mehrschichtigen Aufbau besteht. Durch Verwendung von Farbfiltern wird unter Umgebungslicht der reflektierte und transmittierte Lichtanteil in den Schichten verändert und damit die gesamte reflektierte Farbe variiert. Brillante Schmucksteine sind nicht Gegenstand der Anmeldung. Aus der CN201700538 (U) ist ein Ohrring als Schmuckstück bekannt, bei dem sich mit einer Batterie, einem Stromkreis und farblich veränderbaren LEDs Farbeffekte erzielen lassen. Es ist nicht Gegenstand der CN201700538 (U), brillante Schmucksteine zur Verfügung zu stellen. Die GB 798,080 A offenbart einen auf der Rückseite beschichteten Schmuckstein, der seine Wirkung durch das von oben auf den Schmuckstein fallende Umgebungslicht erhält. In der US 2007/0274160 A1 ist eine Uhr beschrieben, die mit beleuchteten Schmucksteinen verziert ist.

Aufgabe der vorliegen Erfindung ist es, einen farblich schaltbaren Verbundkörper zu realisieren, der eine Farbänderung mit einem brillanten Erscheinungsbild (vide infra) verbindet.

**Beschreibung der Erfindung**

Überraschenderweise wurde gefunden, dass Schmucksteine durch das Aufbringen einer wellenlängenselektiven Schicht mit speziellen Reflexions- und Transmissionseigenschaften und durch Kombination mit einer farblich umschaltbaren Auflagefläche ein brillantes Erscheinungsbild aufweisen. Unter einem brillanten Erscheinungsbild wird erfindungsgemäß ein Reflexionsverhalten verstanden, bei dem das Licht nicht nur diffus reflektiert wird, sondern auch einzelne akzentuierte Reflexionslichtpunkte vorhanden sind. Die erfindungsgemäßen Verbundkörper haben nicht nur eine verbesserte ästhetische Wirkung, sie eignen sich auch sehr gut als optische Signalgeber (vide infra).

Gegenstand der vorliegenden Erfindung ist daher ein farblich veränderbares Schmuckelement, welches a) einen transparenten Schmuckstein mit plan-konvexer Geometrie, b) eine farblich veränderbare Auflagefläche enthält, und c) eine wellenlängenselektive Schicht und c) die zwischen dem transparenten Schmuckstein (B) und der farblich veränderbaren Auflagefläche (D) angeordnet ist.

Die Komponenten a) - c) des farblich veränderbares Schmuckelementes sind vorzugsweise mit einem Klebstoff untereinander verbunden. Wird der Klebstoff in einer bevorzugten Ausführungsform direkt auf dem transparenten Schmuckstein aufgebracht, beträgt die Abweichung des Brechungsindex des Klebstoffs vom Brechungsindex des dekorativen Schmuckelementes weniger als ± 20%. Ist der Brechungsindexunterschied zu groß, kommt es zu unerwünschten Reflexionsverlusten. In einer bevorzugten Ausführungsform besteht das dekorative Schmuckelement im Wesentlichen aus den Komponenten a) - c) in der genannten Abfolge, wobei die Komponenten a) - c) vorzugsweise mit Klebstoff verbunden sind.

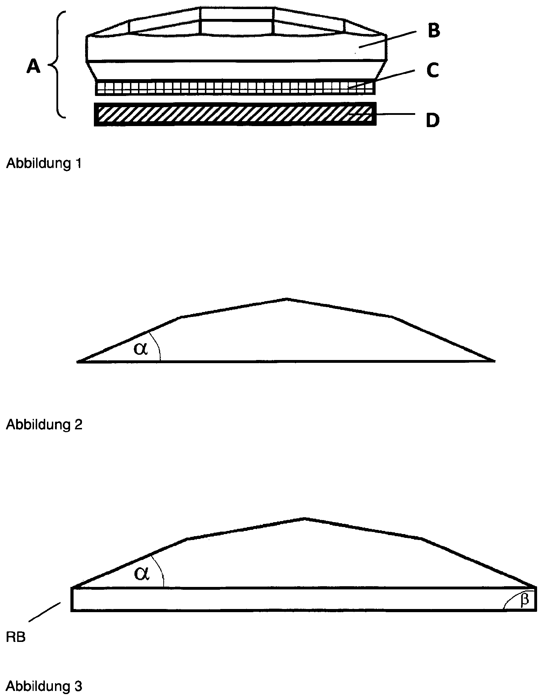

In Abbildung 1 ist eine mögliche Aufbaukombination des dekorativen Schmuckelementes (Verbundkörper) dargestellt, wobei die Bezugszeichen folgende Bedeutung haben: A) schaltbares Schmuckelement, B) plan-konvexer Schmuckstein, C) wellenlängenselektive Schicht, D) farblich veränderbare Auflagefläche.

Einsatzmöglichkeiten dieser Erfindung liegen sowohl im ästhetischen als auch im funktionalen Bereich. Die Erfindung kann beispielsweise auf dem Gebiet der Wearable-Technology eingesetzt werden. Produkte auf diesem Gebiet können häufig mit Hilfe sensorischer Steuerelemente bestimmte Messwerte erfassen. Das Erreichen eines kritischen Messwertes könnte beispielsweise durch eine Farbänderung eines Displays signalisiert werden. Kritische Werte können der Pulsschlag, die Körpertemperatur, der Kalorienverbrauch, elektromagnetische Strahlung und sonstige mit Sensoren erfassbare Größen sein.

Eine Anwendungsmöglichkeit des erfindungsgemäßen dekorativen Schmuckelementes (ein Verbundkörper), stellen beispielsweise mit Sensoren ausgestattete Armbänder dar, die bei Erreichen eines kritischen Messwertes die Farbe der Auflagefläche ändern. Dadurch erhält das Armband ein farblich veränderbares (= schaltbares) Erscheinungsbild. Nicht nur Armbänder, sondern beispielsweise auch Schmuckstücke wie Armreifen oder Halsketten sind in dieser Ausführungsform denkbar.

Die Anwendung des dekorativen Schmuckelementes ist nicht auf den Bereich Wearable-Technology unter Verwendung von sensorischen Steuerelementen beschränkt. Die Schmuckelemente können auch aus rein ästhetischen Gesichtspunkten in Armbändern oder Halsketten verwendet werden. Die Verbindung eines transparenten Schmucksteines mit einer wellenlängenselektiven Schicht und einer farblich veränderbaren Auflagefläche ermöglicht nicht nur den Einsatz als Signalelement sondern eröffnet im Hinblick auf Ästhetik und Design vielfältige Einsatzmöglichkeiten.

Vorzugsweise hat der transparente Schmuckstein eine Facettierung, um das brillante Erscheinungsbild zu verstärken. Bei der bevorzugten plan-konvexen Ausführungsform wird der Schmuckstein flächenmäßig optimal durchleuchtet. Unter einer plan-konvexen Geometrie wird erfindungsgemäß verstanden, dass die Auflagefläche des Schmucksteins eben ist. Dessen Oberseite hat vorwiegend konvex gekrümmte Bereiche und weist Facetten auf. In einer bevorzugten Ausführungsform entsprechen die vorwiegend konvex gekrümmten Bereiche wenigstens 50% der Oberfläche, besonders bevorzugt mindestens 70%, ganz besonders bevorzugt mindestens 80%, insbesondere sind 100% bevorzugt. Der Schmuckstein kann auf der Oberseite mittig eine zur Auflagefläche parallele Facette oder konkave Krümmungen aufweisen. Auch seitlich im Randbereich (vide infra) könnten konkave Krümmungen vorhanden sein, beispielsweise um die Schmucksteine in eine Fassung einzupassen. Bei runden Schmucksteinen wird der Randbereich häufig als Rundiste bezeichnet.

Vorzugsweise liegt der Neigungswinkel $\alpha$ der ersten Facette des transparenten facettierten Schmucksteines, bezogen auf die Grundfläche bzw. waagrechte Auflagefläche des Schmucksteines, im Winkelbereich von 10° bis 40° (vgl. auch Abb. 2 und 3). Dies hat den Vorteil, dass die Homogenität der Farbe auch bei seitlicher Betrachtung des Schmucksteines bis ca. 35° noch gut erhalten bleibt. Liegt der Schmuckstein auf der planen Seite waagrecht auf, dann ist der bevorzugte Neigungswinkel $\alpha$ der spitze Winkel, der mit der waagrechten Auflagefläche eingeschlossen wird. Der Betrachtungswinkel wird hingegen von der senkrechten Richtung aus gemessen. Der sogenannte Randbereich eines Schmucksteines (RB = Randbereich, Abb. 3) hat vorzugsweise einen Neigungswinkel $\beta$ von 80° bis 100°. Beispielhaft ist in Abbildung 2 die Kontur eines Schmucksteins ohne Randbereich dargestellt. Beispielhaft ist in Abbildung 3 der Randbereich mit einem Neigungswinkel $\beta$ von 90° dargestellt.

Für die optischen Effekte ist die Transparenz des Schmucksteines eine wesentliche Eigenschaft. Die Transparenz des Schmucksteines hängt mit dessen Transmissionseigenschaften zusammen. Erfindungsgemäß wird unter der Transparenz des Schmucksteines eine Transmission des einfallenden Lichtes von wenigstens 50% verstanden, vorzugsweise mehr als 80%.

Die Komponenten des dekorativen Schmuckelementes werden erfindungsgemäß bevorzugt mit Klebstoff verbunden, besonders bevorzugt sind UV-härtende (280 - 380 nm) bzw. lichthärtende (380 - 780 nm) Klebstoffe, da sie sehr schnell unter UV- bzw. Lichteinwirkung aushärten. Dem Fachmann sind sowohl die UV-härtenden als auch lichthärtenden Klebstoffe hinlänglich bekannt. Aus optischen Gründen sollte der Klebstoff ausreichend transparent sein, damit möglichst viel Licht auf der wellenlängenselektiven Schicht ankommt. Er hat vorzugsweise eine Transparenz von mindestens 80%, besonders bevorzugt von mindestens 90%. Erfindungsgemäß ganz besonders bevorzugt ist die Verwendung von UV-härtenden bzw. lichthärtenden Acrylat-Klebstoffen, insbesondere von modifizierten Urethanacrylat-Klebstoffen. Diese werden von zahlreichen Firmen vertrieben, beispielsweise von Delo unter der Bezeichnung Delo-Photobond® GB 368, ein Klebstoff, der durch UV-Licht und sichtbares Licht im Bereich von 320-420 nm ausgehärtet werden kann. Im Sinne der Erfindung sind auch andere Klebstoffe einsetzbar, beispielsweise Epoxidharzklebstoffe wie zum Beispiel EPO-TEK® 301-2 der Firma EPOXY-Technology. Die Verfahren zur Bestimmung der Transparenz sind dem Fachmann hinlänglich bekannt. Es sei hier noch ausdrücklich erwähnt, dass es auch andere Verbindungsmöglichkeiten der Komponenten des dekorativen Schmuckelementes gibt, beispielsweise mechanische, zum Beispiel durch geeignete Halterungen, so dass eine Verbindung mit Klebstoff nicht zwingend ist.

In einer bevorzugten Ausführungsform wird die wellenlängenselektive Schicht (vide infra) direkt am Schmuckstein auf der der Facettierung gegenüberliegenden planen Seite aufgebracht (Abb. 1). Diese beschichtete Seite wird vorzugsweise mit der farblich veränderbaren Auflagefläche verklebt. In einer alternativen erfindungsgemäß bevorzugten Ausführungsform wird die wellenlängenselektive Schicht auf der farblich veränderbaren Auflagefläche aufgebracht. Die so gefertigte farblich veränderbare Auflagefläche wird dann vorzugsweise mit dem transparenten Schmuckstein verklebt. Die Verklebung der einzelnen Teile ist jedoch nicht zwingend notwendig.

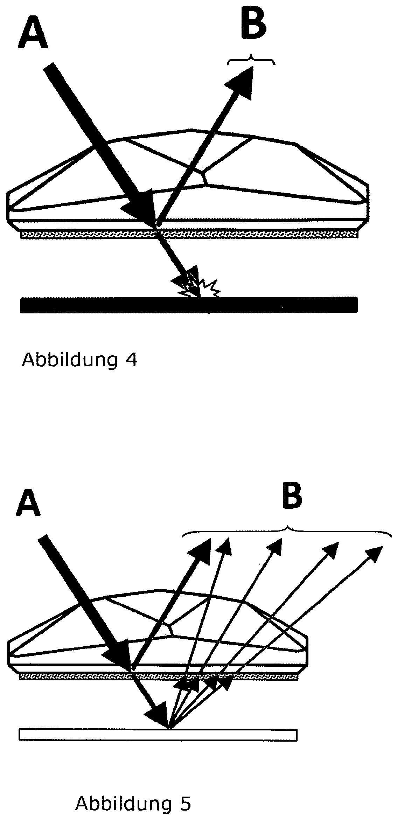

Vorzugsweise ist die wellenlängenselektive Schicht eine wellenlängenselektive Beschichtung (vide infra) oder eine wellenlängenselektive Folie (vide infra). Wellenlängenselektive Beschichtungen haben sich als vorteilhaft erwiesen, da sie sehr gute Reflexions- und Transmissionseigenschaften haben. Die wellenlängenselektive Folie (vide infra) kann entweder alternativ oder ergänzend zu einer wellenlängenselektiven Beschichtung (vide infra) eingesetzt werden. Sie ist bevorzugt durch Klebstoffschichten mit der farblich veränderbaren Auflagefläche und mit dem transparenten Schmuckstein verbunden. Die Verklebung der einzelnen Teile ist aber nicht zwingend erforderlich. Vorzugsweise werden als Auflagefläche elektronisch schaltbare Displays verwendet; dadurch lässt sich eine Farbänderung mit elektronischer Ansteuerung realisieren. Erfindungsgemäß bevorzugt findet dieser Wechsel zwischen weißer und schwarzer Farbe statt. Das Wirkungsprinzip des farblich veränderbaren Schmucksteines wird in den Abbildungen 4 und 5 dargestellt. Ist die Auflagefläche schwarz, wie in Abbildung 4, dann wird der durch die wellenlängenselektive Schicht transmittierte Lichtanteil überwiegend absorbiert, und es kann nur der an der wellenlängenselektiven Schicht reflektierte Lichtanteil wahrgenommen werden. Bei einer weißen Auflagefläche, wie in Abbildung 5, wird der durch die wellenlängenselektive Schicht transmittierte Lichtanteil an der weißen Fläche reflektiert und überlagert sich mit dem an der wellenlängenselektiven Schicht reflektierten Lichtanteil zu einer neuen Farbe. Der weiße Hintergrund reflektiert vorzugsweise diffus. Das hat den Vorteil, dass der Farbwechsel in einem größeren Winkelbereich erfasst werden kann.

Als Auflagefläche eignen sich beispielsweise auch bistabile Displays (vide infra), zum Beispiel E-Paper oder E-Ink®. Sie haben den Vorteil, dass sie nur beim Farbwechsel selbst Energie benötigen. Das ist für Wearable-Technologies mit deren geringen Energieressourcen vorteilhaft. Andere Display-Technologien, beispielsweise OLED, TFT, LCD, sind aber ebenso einsetzbar.

Zur Messung des Farbwechsels des dekorativen Schmuckelementes wird der L*a*b* Farbraum gemäß DIN EN ISO 11664-4 verwendet. Bestimmt man quantitativ den Farbort des Schmuckelementes, beispielsweise bei erfindungsgemäß bevorzugter weißer und schwarzer Auflagefläche, dann erhält man vom gemessenen Schmuckelement bei weißer Auflagefläche den Farbort $p = (L_p^*, a_p^*, b_p^*)$ und bei schwarzer Auflagefläche den Farbort $v = (L_v^*, a_v^*, b_v^*)$. Der Farbwechsel wird durch den Abstand des Farbortes "p" vom Farbort "v" berechnet. Der Abstand des Farbortes "p" vom Farbort "v" lautet

$$\Delta E = \sqrt{\left(L_p^* - L_v^*\right)^2 + \left(a_p^* - a_v^*\right)^2 + \left(b_p^* - b_v^*\right)^2}$$

. Erfindungsgemäß bevorzugt ist ein Abstand $\Delta E$ der größer oder gleich 5 ist, d.h. $\Delta E \geq 5$, damit der Farbwechsel für das menschliche Auge unterscheidbar ist.

Gegenstand der Erfindung ist ebenfalls das Verfahren zum Verändern der Farbe eines dekorativen Schmuckelementes, indem man die Farbe der Auflagefläche mittels einer elektronischen Schaltung verändert.

## Transparenter Schmuckstein

Der transparente Schmuckstein kann aus verschiedensten Materialien gefertigt sein, beispielsweise aus transparentem Glas, Kunststoff, transparenter Keramik oder einem transparenten Edelstein. Erfindungsgemäß bevorzugt sind transparente Schmucksteine, die aus Glas oder aus Kunststoff hergestellt sind, da diese am kostengünstigsten sind. Aufgrund seiner hervorragenden optischen Wirkung ist Glas erfindungsgemäß bevorzugt

## Glas

Die Erfindung ist bezüglich der Zusammensetzung des Glases prinzipiell nicht limitiert, solange dieses transparent ist. Unter Glas wird eine eingefrorene unterkühlte Flüssigkeit verstanden, die einen amorphen Festkörper bildet. Der Brechungsindex des Glases befindet sich bevorzugt im Bereich von 1,5 bis 1,9. Erfindungsgemäß können sowohl oxidische Gläser als auch Chalkogenidgläser, metallische Gläser oder nicht-metallische Gläser eingesetzt werden. Auch Oxy-Nitrid-Gläser können geeignet sein. Es kann sich um Einkomponenten- (z.B. Quarzglas) oder Zweikomponenten- (z.B. Alkaliboratglas) oder Mehrkomponentengläser (Kalk-Natron-Glas) handeln. Das Glas kann durch Schmelzen, durch Sol-Gel-Prozesse oder auch durch Stoßwellen hergestellt werden. Die Verfahren sind dem Fachmann bekannt. Erfindungsgemäß bevorzugt sind anorganische Gläser, insbesondere oxidische Gläser. Hierzu gehören Silikatgläser, Boratgläser oder Phosphatgläser. Besonders bevorzugt sind bleifreie Gläser. Für die Herstellung der facettierten transparenten Schmucksteine werden silikatische Gläser bevorzugt. Silikatische Gläser haben gemeinsam, dass ihr Netzwerk hauptsächlich aus Siliziumdioxid ($SiO_2$) gebildet wird. Durch Zugabe weiterer Oxide wie beispielsweise Aluminiumoxid oder verschiedener Alkalioxide entstehen die Alumo- oder Alkali-Silikatgläser. Treten als Hauptnetzwerkbildner eines Glases Phosphorpentoxid oder Botrioxid auf, spricht man von Phosphat- bzw. Boratgläsern, deren Eigenschaften ebenfalls durch Zugabe weiterer Oxide eingestellt werden können. Auch diese Gläser sind im Sinne der Erfindung einsetzbar. Die genannten Gläser bestehen größtenteils aus Oxiden, weshalb man sie zusammenfassend als oxidische Gläser bezeichnet. In einer erfindungsgemäß bevorzugten Ausführungsform enthält die Glaszusammensetzung folgende Komponenten: (a) etwa 35 bis etwa 85 Gew.-% $SiO_2$ (b) 0 bis etwa 20 Gew.-% $K_2O$; (c) 0 bis etwa 20 Gew.-% $Na_2O$; (d) 0 bis etwa 5 Gew.-% $Li_2O$; (e) 0 bis etwa 13 Gew.-% ZnO; (f) 0 bis etwa 11 Gew.-% CaO; (g) 0 bis etwa 7 Gew.-% MgO; (h) 0 bis etwa 10 Gew.-% BaO; (i) 0 bis etwa 4 Gew.-% $Al_2O_3$; (j) 0 bis etwa 5 Gew.-% $ZrO_2$; (k) 0 bis etwa 6 Gew.-% $B_2O_3$; (l) 0 bis etwa 3 Gew.-% F; (m) 0 bis etwa 2,5 Gew.-% Cl. Alle Mengenangaben sind dabei so zu verstehen, dass sie sich jeweils zu 100 Gew.-% ergänzen.

Die Facettierung der Glasobjekte wird durch Schleif- und Poliertechniken erhalten, die dem Fachmann hinlänglich bekannt sind. Erfindungsgemäß geeignet ist beispielsweise ein bleifreies Glas, insbesondere das von der Firma Swarovski.

## Kunststoff

Als weiterer Rohstoff für die Herstellung des transparenten Schmucksteines können transparente Kunststoffe eingesetzt werden. Erfindungsgemäß geeignet sind alle Kunststoffe, die nach dem Härten der Monomere transparent sind; diese sind dem Fachmann hinlänglich bekannt. Hier finden unter anderem folgende Materialien Verwendung: Acrylglas (Polymethylmetacrylate, PMMA), Polycarbonat (PC), Polyvinylchlorid (PVC), Polystyrol (PS), Polyphenylenether (PPO), Polyethylen (PE), Poly(n-methylmethacrylimid) (PMMI). Die Vorteile der transparenten Kunststoffe gegenüber Glas liegen insbesondere im geringeren spezifischen Gewicht, das nur rund die Hälfte des Glases beträgt. Auch andere Materialeigenschaften sind gezielt einstellbar. Kunststoffe sind zudem oft einfacher zu bearbeiten als Glas. Nachteilig wirkt sich der im Vergleich zu Glas geringe Elastizitätsmodul und die geringe Oberflächenhärte sowie der massive Festigkeitsabfall bei Temperaturen ab ca. 70°C aus. Ein erfindungsgemäß bevorzugter Kunststoff ist Poly(n-methylmethacrylimid), der beispielsweise von Evonik unter dem Namen Pleximid® TT70 vertrieben wird. Pleximid® TT70 hat einen Brechungsindex von 1,54 und einen Transmissionsgrad von 91 %, gemessen nach ISO 13468-2 unter Verwendung von D65-Normlicht.

## Geometrie

Die geometrische Gestaltung des transparenten Schmucksteines ist grundsätzlich nicht eingeschränkt und stark von Designaspekten geprägt. Die Grundform des Schmucksteines ist vorzugsweise quadratisch, rechteckig oder rund. Der Schmuckstein hat erfindungsgemäß bevorzugt eine facettierte Oberfläche, da Facetten für ein brillantes Erscheinungsbild vorteilhaft sind. Schmucksteine mit plan-konvexer Geometrie sind erfindungsgemäß bevorzugt, da der Schmuckstein gut durchleuchtet wird. In Verbindung mit den Facetten ergibt sich in diesem Fall ein besonders brillantes Erscheinungsbild. Haben die Facetten einen bevorzugten Neigungswinkel $\alpha$ von 10° bis 40°, dann ist auch bei seitlicher Betrachtung ein farblich homogener Gesamteindruck vorhanden. Bezüglich der geometrischen Form der Facetten gibt es prinzipiell keine Begrenzung, bevorzugt sind aber Facetten in Form eines Trapezes oder Dreieckes sowie rechteckige oder quadratische Facetten.

## Wellenlängenselektive Schicht

Die wellenlängenselektive Schicht ist wesentlich dafür verantwortlich, dass der Schmuckstein sein brillantes Erscheinungsbild erhält und dadurch erst als Schmuckstein wahrgenommen wird. Sie befindet sich zwischen dem transparenten Schmuckstein und der farblich veränderbaren Auflagefläche. Vorzugsweise ist die wellenlängenselektive Schicht eine wellenlängenselektive Folie oder eine wellenlängenselektive Beschichtung. Die wellenlängenselektive Beschichtung wird vorzugsweise durch PVD, CVD oder nasschemische Verfahren hergestellt. Eine wellenlängenselektive Schicht kann aber ebenso durch eine mikrostrukturierte Oberfläche erhalten werden. Dem Fachmann sind die Methoden zur Mikrostrukturierung wohl bekannt.

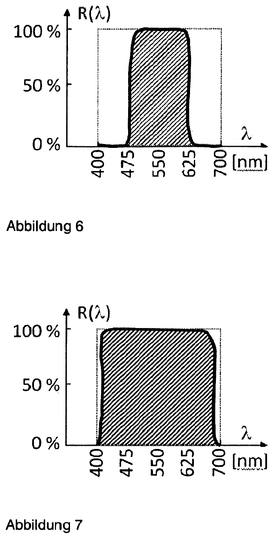

Infolge der Reflexion und Transmission eines definierten Bereichs des sichtbaren Lichtspektrums wirkt die wellenlängenselektive Schicht wie ein Filter. Das optische Element gewinnt dadurch an Brillanz und erscheint für den Betrachter in einer bestimmten Farbe. Die Brillanz wird ferner durch die Facettierung des plan-konvexen Objektes unterstützt. In einer bevorzugten Ausführungsform der Erfindung reflektiert und transmittiert die wellenlängenselektive Schicht einen Anteil des Lichtes im Bereich von 380 - 780 nm, d.h. im sichtbaren Bereich. Erfindungsgemäß besonders bevorzugt ist eine wellenlängenselektive Schicht, die im sichtbaren Wellenlängenbereich von 400 bis 700 nm einen gemittelten Reflexionsgrad von weniger als 75% hat. Unter dem gemittelten Reflexionsgrad wird erfindungsgemäß das Verhältnis vom Integral der Reflexionskurve (Abb. 6, schraffierte Fläche) der wellenlängenselektiven Schicht zum Integral der prinzipiell maximal möglichen Reflexionskurve (Abb. 6, Fläche unter gepunkteter Linie) über den jeweils gleichen Wellenlängenbereich in Prozent verstanden. Der Integrationsbereich ist der Wellenlängenbereich von 400 nm bis 700 nm. Bei einem gemittelten Reflexionsgrad der wellenlängenselektiven Schicht über 75% hat die farblich veränderbare Auflagefläche durch die stärkere Reflexion an der wellenlängenselektiven Schicht einen geringeren Einfluss auf einen sichtbaren Farbwechsel des dekorativen Schmuckelementes. Der gemittelte Reflexionsgrad von weniger als 75% verstärkt den Farbwechseleffekt und ist daher erfindungsgemäß bevorzugt. Die Abbildung 6 zeigt ein Beispiel für einen gemittelten Reflexionsgrad von weniger als 75%; das Integral unter der gepunkteten Linie im Wellenlängenbereich von 400 nm bis 700 nm wird dabei auf 100% normiert Die Abbildung 7 zeigt ein Beispiel für einen nicht ganz optimalen, über 75% liegenden gemittelten Reflexionsgrad.

Das einfallende Licht wird an der wellenlängenselektiven Schicht teilweise reflektiert und teilweise transmittiert. Die wellenlängenselektive Schicht ist für die Aufspaltung des Lichtes und das brillante Erscheinungsbild des dekorativen Schmuckelementes von großer Bedeutung. Eine diffuse Reflexion an der wellenlängenselektiven Schicht vermindert das brillante Erscheinungsbild, da keine akzentuierten Lichtpunkte entstehen. Deshalb ist vorzugsweise der Streulichtanteil des reflektierten Lichtes der wellenlängenselektiven Schicht kleiner als 5%.

Die wellenlängenselektive Schicht wird vorzugsweise direkt auf der planen Seite des Schmucksteines aufgebracht oder alternativ dazu auf der farblich veränderbaren Auflagefläche.

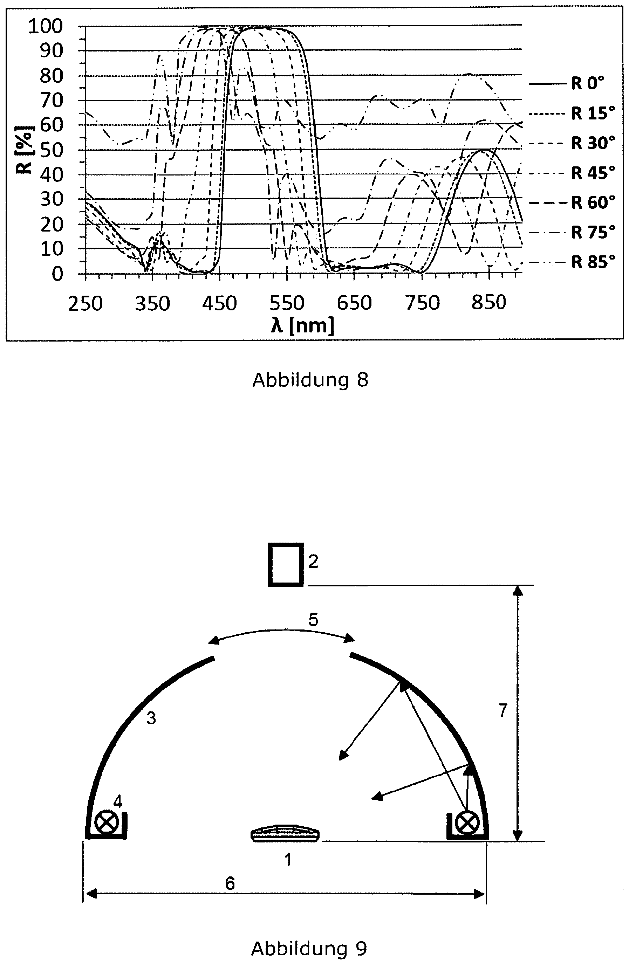

Die wellenlängenselektive Schicht hat die Eigenschaft, dass die Reflexion an ihr winkelabhängig ist. Eine Veränderung des Betrachtungswinkels bewirkt eine Veränderung des reflektierten Spektrums. In Abbildung 8 wurde für Beschichtungsvariante 1 der Tabelle 1 (vide infra) die Veränderung des reflektierten Spektrums für verschiedene Betrachtungswinkel dargestellt. Der Betrachtungswinkel 0° entspricht einem senkrechten Blick auf den Schmuckstein, und der Betrachtungswinkel von 85°, gemessen von einer senkrechten Achse, entspricht einem Blick von der Seite. Die Veränderung des reflektierten Spektrums der wellenlängenselektiven Schicht in Abhängigkeit von der Blickrichtung in Verbindung mit erfindungsgemäß bevorzugt facettierten Schmucksteinen führt dazu, dass durch die Facetten unterschiedliche Farbanteile reflektiert werden. Liegt der bevorzugte Neigungswinkel $\alpha$ der Facette im Winkelbereich von 10° bis 40°, dann bleibt auch bei seitlicher Betrachtung die Homogenität der Farbe erhalten.

Wird als Verbindungselement der einzelnen Komponenten des dekorativen Schmuckelementes ein UV-härtender bzw. lichthärtender Klebstoff verwendet, dann ist für die Aushärtung des Klebstoffs die Transmissionseigenschaft der wellenlängenselektiven Schicht von Bedeutung. Um die einzelnen Komponenten des dekorativen Schmuckelementes mit UV- bzw. lichthärtendem Klebstoff verkleben zu können, ist es erforderlich, dass die wellenlängenselektive Schicht ausreichend transparent ist. Erfindungsgemäß bevorzugt transmittiert die wellenlängenselektive Schicht im Wellenlängenbereich von 360 nm bis 420 nm mindestens 20%.

Wellenlängenselektive Folien

Wellenlängenselektive Folien können alternativ oder ergänzend zur wellenlängenselektiven Beschichtung (vide infra) eingesetzt werden. Wellenlängenselektive Folien als Reflexionsfilter sind im Handel unter der Bezeichnung "Radiant Light Film" erhältlich. Hierbei handelt es sich um mehrschichtige polymere Filme, die auf andere Materialien appliziert werden können. Diese optischen Folien sind Bragg-Spiegel und reflektieren einen hohen Anteil des sichtbaren Lichts und erzeugen farbige Effekte. In Abhängigkeit vom Lichteinfallswinkel werden die verschiedenen Wellenlängen des Lichtes reflektiert, und es kommt zu Interferenzerscheinungen. Dadurch ändert sich in Abhängigkeit vom Blickwinkel die Farbe.

Erfindungsgemäß besonders bevorzugte Folien bestehen aus mehrschichtigen polymeren Filmen, deren äußere Schicht ein Polyester ist. Solche Folien werden beispielsweise von der Firma 3M unter dem Namen Radiant Color Film CM 500, unter den Artikel-Nummern 76917, 76922, 76924 und 76926 vertrieben. Die Folien haben ein Reflexionsintervall von 590 - 740 nm bzw. 500 - 700 nm.

Wellenlängenselektive Folien, die nicht auf Reflexion sondern auf Absorption basieren, können ergänzend als Absorptionsfilter verwendet werden, beispielsweise die Folie Roscolux #80 Primary Blue der Firma Rosco. Durch Absorptionsfilter können Farbverschiebungen erreicht werden.

Die wellenlängenselektive Folie wird vorzugsweise mit Hilfe eines transparenten Klebstoffs mit der farblich veränderbaren Auflagefläche und dem transparenten Schmuckstein verbunden. In einer bevorzugten Ausführungsform weicht der Brechungsindex des Klebstoffs weniger als ± 20 % von dem Brechungsindex des transparenten Schmucksteines ab. In einer besonders bevorzugten Ausführungsform ist die Abweichung kleiner als ± 10 %, ganz besonders bevorzugt kleiner als ± 5 %. Nur auf diese Weise wird gewährleistet, dass Reflexionsverluste aufgrund der unterschiedlichen Brechungsindizes minimiert werden können.

Die Brechungsindizes können auch durch Aufrauhung der jeweiligen Grenzschichten aneinander angepasst werden (Mottenaugeneffekt). Sogenannte "Mottenaugenoberflächen" bestehen aus feinen Noppenstrukturen, die das Brechungsverhalten des Lichtes nicht schlagartig, sondern idealerweise kontinuierlich verändern. Dadurch werden die scharfen Grenzen zwischen den unterschiedlichen Brechzahlen beseitigt, sodass der Übergang fast fließend erfolgt und das Licht ungehindert hindurch dringen kann. Die Strukturgrößen, die dafür erforderlich sind, müssen kleiner als 300 nm sein. Durch Mottenaugeneffekte wird sichergestellt, dass die Reflexion an den Grenzschichten minimiert wird und somit eine höhere Lichtausbeute beim Durchgang durch die Grenzschichten erzielt wird.

Wellenlängenselektive Beschichtung

Aufgrund ihrer Reflexions- und Transmissionseigenschaften eignen sich auch wellenlängenselektive Beschichtungen zum Aufbau einer wellenlängenselektiven Schicht. Die Beschichtungsmaterialien sind dem Fachmann wohl bekannt. In einer bevorzugten Ausführungsform der Erfindung enthalten die wellenlängenselektiven Beschichtungen wenigstens ein Metall und/oder eine Metallverbindung, vorzugsweise mit einem Aufbau, der eine Abfolge von $SiO_2$- und $TiO_2$- Schichten umfasst. Weitere mögliche Beschichtungsmaterialien umfassen neben den Metallen und Metalloxiden, beispielsweise auch Metallnitride, Metallfluoride, Metallcarbide oder eine beliebige Kombination dieser Verbindungen in beliebiger Reihenfolge, die mittels einer der gängigen Beschichtungsverfahren auf die Schmucksteine oder die farblich veränderbare Auflagefläche aufgebracht werden. Es können auch aufeinanderfolgende Schichten verschiedener Metalle oder Metallverbindungen aufgebracht werden. Die Verfahren zur Herstellung von Beschichtungen sowie die Beschichtungen selbst sind dem Fachmann hinlänglich bekannt. Hierzu zählen gemäß dem Stand der Technik unter anderem PVD-Verfahren (physical vapour deposition), CVD-Verfahren (chemical vapour deposition), Lackierungsverfahren sowie nasschemische Verfahren. Erfindungsgemäß bevorzugt sind PVD-Verfahren.

Bei den PVD-Verfahren handelt es sich um eine Gruppe von vakuumbasierten Beschichtungsverfahren bzw. Dünnschichttechnologien, die dem Fachmann hinlänglich bekannt sind und insbesondere zur Beschichtung von Glas und Kunststoff in der Optik- und der Schmuckindustrie eingesetzt werden. Im PVD-Prozess wird das Beschichtungsmaterial in die Gasphase überführt. Das gasförmige Material wird anschließend zum zu beschichtenden Substrat geführt, wo es kondensiert und die Zielschicht bildet.

Die Beschichtungsmaterialien werden thermisch in die Gasphase überführt, indem eine mit dem Beschichtungsmaterial gefüllte Quelle beispielsweise resistiv oder induktiv beheizt und das Material bis zum Siedepunkt erhitzt wird. Ein weiteres thermisches Verdampfungsverfahren ist das sogenannte Elektronenstrahlverdampfen, bei dem die Verdampfungsenergie mittels eines energiereichen Elektronenstrahls erzeugt wird. Für die thermischen Verdampfungsverfahren eignet sich beispielsweise das Modell BAK1101 der Firma Evatec oder Balzers BAK760.

Das Sputtern ist ein weiteres Verfahren, um das Beschichtungsmaterial in die Gasphase zu überführen. Beim Sputtern werden energiereiche Gasionen in einer Vakuumkammer auf die Oberfläche eines Targets beschleunigt. Das Target ist aus dem Beschichtungsmaterial gefertigt. Aus dem Target werden durch mechanische Stöße Atome herausgelöst. Die herausgelösten Teilchen treffen auf das zu beschichtende Substrat und kondensieren an der Oberfläche. Für das Sputtern ist beispielsweise das Modell Radiance der Firma Evatec geeignet.

Mit einigen dieser PVD-Verfahren (Sputtern, Laserstrahlverdampfen, thermische Bedampfung, etc.) können niedrige Prozesstemperaturen verwirklicht werden. Dadurch ist es möglich, selbst niedrigschmelzende Kunststoffe zu beschichten. Eine Vielzahl von Metallen kann auf diese Weise in sehr reiner Form in dünnen Schichten abgeschieden werden. Führt man den Prozess in Gegenwart von Reaktivgasen wie Sauerstoff durch, so lassen sich auch Metalloxide abscheiden. Ein typisches Schichtsystem kann je nach Anforderung an Funktion und optische Erscheinung aus nur einer, aber auch aus einer Vielzahl von Schichten aufgebaut sein.

Für den Aufbau einer wellenlängenselektiven Beschichtung eignen sich beispielsweise weitgehend absorptionsfreie dielektrische Materialien. Durch geeignete Wahl von Beschichtungsmaterialien, Schichtanzahl und Schichtdicken kann der gewünschte Reflexions- und Transmissionsgrad eingestellt werden. Für die weitgehend absorptionsfreien dielektrischen Materialien eignen sich vorzugsweise folgende Beschichtungsmaterialien: $MgF_2$, $SiO_2$, CeF3, $Al_2O_3$, $CeO_3$, $ZrO_2$, $Si_3N_4$, $Ta_2O_5$, $TiO_2$ oder eine beliebige Kombination dieser Verbindungen in beliebiger Schichtabfolge.

Es ist des Weiteren möglich, in der wellenlängenselektiven Schicht absorbierende Materialien zu verwenden. Dadurch ergeben sich weitere Gestaltungsmöglichkeiten im Hinblick auf die Farbgebung. Als absorbierende Materialien im Schichtsystem eignen sich beispielsweise Cr, $Cr_2O_3$, Fe, $Fe_2O_3$, Al, Au, SiO, Mn, Si, Cu, Ag, Ti oder eine beliebige Kombination dieser Verbindungen in beliebiger Schichtabfolge.

Durch Kombination der wellenlängenselektiven Schicht mit einer absorbierenden Folie kann die Farbe zusätzlich vorteilhaft verändert werden. Die Absorptionsfolie befindet sich je nach Aufbau zwischen der wellenlängenselektiven Schicht und der farblich veränderbaren Auflagefläche oder zwischen der wellenlängenselektiven Schicht und dem dekorativen Schmuckstein.

Erfindungsgemäß bevorzugt sind Beschichtungen, die aus dielektrischen Materialien aufgebaut sind und aufgrund von Interferenzerscheinungen nur gewisse Anteile des sichtbaren Lichtes transmittieren bzw. reflektieren und dadurch farbig wirken, beispielsweise eine Mehrfach-Abfolge von $TiO_2$ und $SiO_2$. Die Schichtanzahl und die Schichtdicke können je nach Farbe stark variieren. Es sind verschiedenste Farben mit hoher bis geringer Sättigung möglich.

**Farblich veränderbare Auflagefläche**

Die farblich veränderbare Auflagefläche ist vorzugsweise ein elektronisch schaltbares Display, das durch elektronische Ansteuerung die Farbe wechselt. Der Farbwechsel findet vorzugsweise zwischen zwei Farben statt, besonders bevorzugt zwischen den Farben Weiß und Schwarz. Der Wechsel zwischen den Farben Schwarz und Weiß ermöglicht einen gut sichtbaren Farbwechsel des dekorativen Schmuckelementes. Im Sinne der Erfindung kann der Farbwechsel auch zwischen anderen Farben stattfinden.

Bevorzugte elektronisch schaltbare Displays sind bistabile Displays, da bei diesen nur für das Umschalten beim Farbwechsel Energie aufgewendet werden muss. Der geänderte Zustand bleibt ohne Energieaufwand erhalten. Werden die farblich veränderbaren Schmucksteine mit Batterie oder photovoltaischen Zellen betrieben, ist eine energiesparende Versorgung von großer Bedeutung.

Bistabile Displays sind beispielsweise E-Paper, E-Ink® oder bistabile LCD. Als E-Paper bezeichnet man elektronisches Papier. Dabei handelt es sich um eine passive, auf Reflexion aufgebaute, daher nicht selbst leuchtende Anzeigentechnik. Das E-Paper enthält geladene weiße und/oder geladene schwarze Mikrokapseln, die sich in einem zähflüssigen Medium befinden. Durch kurzzeitiges Anlegen einer elektrischen Spannung verändern die geladenen Mikrokapseln ihre Position und werden dadurch sichtbar oder verschwinden: Das Display kann somit auf Basis des Effektes der Elektrophorese die Farbe wechseln, beispielsweise zwischen Weiß und Schwarz. Die Verwendung von Mikrokapseln erlaubt auch, flexiblen Kunststoff anstelle von Glas als Trägermaterial zu verwenden. E-Ink® ist eine Produktbezeichnung der E Ink® Corporation und daher ein Synonym für die Bezeichnung E-Paper. Als E-Paper eignet sich beispielsweise das Produkt AEP0213021201042_001 der Firma Admatec.

Liquid Crystal Displays (LCDs) sind auch als farblich veränderbare Auflagefläche einsetzbar. Es handelt sich dabei um Flüssigkristallanzeigen. Sie werden vielfältig eingesetzt, beispielsweise in Monitoren, Computerspielen und vor allem in mobilen Geräten der Kommunikations- und Unterhaltungselektronik. LCDs gibt es sowohl mit Stromversorgung als auch in bistabiler Ausführung. Basis der LCD-Displays sind Flüssigkristallzellen. Bei diesem Displaytyp wird die Polarisationsebene des Lichtes gedreht. Durch Anlegen eines elektrischen Feldes an die Flüssigkristallzelle orientieren sich die Flüssigkristallmoleküle im elektrischen Feld, wodurch die Durchlässigkeit der Flüssigkristallzelle für das Licht gesteuert werden kann.

Bevorzugt sind bistabile LCDs, die ihre Displayanzeige ohne zusätzliche Stromversorgung aufrechterhalten. Energie wird bei diesem Displaytyp nur für das Ändern der Ausrichtung der Flüssigkristalle benötigt. Einmal in Position gebracht, behalten diese ihre Ausrichtung bei, bis sie beim nächsten Anpassen neu orientiert werden. Als bistabiles LCD-Display kann beispielsweise das Produkt LS010B7DH01 der Firma Sharp verwendet werden.

Organic Light Emitting Diodes (OLED) eignen sich ebenfalls als farblich veränderbare Auflagefläche. Die OLED ist ein leuchtendes Dünnschichtbauelement und erzeugt Licht aus elektrischen Ladungen durch Ausnutzung von Elektrolumineszenz. OLEDs bestehen aus einer organischen Schicht oder aus einer Reihe verschiedener dünner organischer Schichten, die zwischen zwei Kontakten eingebettet sind. Einer der Kontakte muss transparent sein, um die Auskopplung des erzeugten Lichtes zu ermöglichen. Die OLED-Technik wird beispielsweise bei Bildschirmen und Displays eingesetzt.

Weitere Display-Varianten, beispielsweise LED oder durch TFT gesteuerte Displays, sind erfindungsgemäß ebenfalls für den Einsatz geeignet. Generell eignen sich sowohl Single-Pixel- als auch Mehr-Pixel-Systeme. Die Displays sind dem Fachmann wohl bekannt.

Als farblich veränderbare Auflagefläche sind ferner temperaturabhängige farblich veränderbare Materialien einsetzbar, beispielsweise thermochrome Folien, Lacke oder Tinten. Die Farbänderung kann reversibel ablaufen. Durch Erwärmung stellt sich eine Farbänderung ein; kühlt das Material ab, dann entsteht wieder die ursprüngliche Farbe. Als thermochrome Folie eignen sich beispielsweise die Produkte R20C5B, R25C5B, R29C4B, R30C5B, R35C1B, R35C5B, R40C5B und R45C5B der Firma LCR Hallcrest, und als thermochrome Tinte eignet sich beispielsweise das Produkt JC21A der Firma LCR Hallcrest. Diese thermochromen Materialien sind dem Fachmann wohl bekannt.

Dekorative Schmuckelemente mit verborgenen Botschaften wie Texte oder Zeichen sind eine weitere interessante Einsatzmöglichkeit. Dabei werden beispielsweise thermochrome Folien mit aufgedruckten Botschaften versehen, die erst durch eine Farbänderung sichtbar werden. Eine beispielsweise in schwarzer Farbe aufgedruckte Textbotschaft ist zum Beispiel mit weißer Auflagefläche zu sehen. Ändert sich die Farbe von weiß auf schwarz, dann ist die Textbotschaft nicht mehr zu erkennen. Das kann beispielsweise für Firmenlogos, Firmenbezeichnungen oder sonstige Zeichen angewendet werden.

Neben den bereits erwähnten farblich veränderbaren Auflageflächen können auch photochrome Materialien wie Folien oder Lacke verwendet werden. Unter Photochromie versteht man eine lichtinduzierte reversible Umwandlung. Auslöser für die Umwandlung ist meist UV-Licht.

## Abbildungsverzeichnis:

Abbildung 1: Aufbau des dekorativen Schmuckelementes A: B = Schmuckstein, C = wellenlängenselektive Schicht, D = farblich veränderbare Auflagefläche.

Abbildung 2: Neigungswinkel $\alpha$ der ersten Facette.

Abbildung 3: Neigungswinkel $\alpha$ der ersten Facette sowie Randbereich und Neigungswinkel $\beta$.

Abbildung 4: prinzipieller Strahlenverlauf bei schwarzer Auflagefläche; A ist das einfallende und B ist das reflektierte Licht.

Abbildung 5: prinzipieller Strahlenverlauf bei weißer Auflagefläche; A ist das einfallende und B ist das reflektierte Licht.

Abbildung 6: Beispiel für einen gemittelten Reflexionsgrad kleiner 75%.

Abbildung 7: Beispiel für einen gemittelten Reflexionsgrad größer 75%.

Abbildung 8: Winkelabhängigkeit des reflektierten Spektrums der Tabelle 1, Blickrichtung von 0° bis 85°.

Abbildung 9: Messaufbau zur Bestimmung des Farbortes:
(1) Schmuckelement, (2) Messkamera, (3) Halbkugel mit reflektierender Innenoberfläche, (4) Lichtquelle, (5) Öffnung mit 2x15°, (6) Durchmesser der Halbkugel, (7) Abstand Halbkugelmittelpunkt zu Kamera

Abbildung 10: Messanordnung zur Brillanzbestimmung:
(1) Schmuckelement, (2) Messkamera, (3) Streuschirm, (4) Lichtquelle, (5) halbdurchlässiger Spiegel, (6) Abstand Schmuckelement zu Streuschirm, (7) Abstand Schmuckelement zu Messkamera

Abbildung 11: Messung der Brillanz mit Beschichtungsvariante 2 bei weißer Auflagefläche.

Abbildung 12: Messung der Brillanz mit Beschichtungsvariante 2 bei schwarzer Auflagefläche.

Abbildung 13: Messung der Brillanz ohne wellenlängenselektive Schicht bei weißer Auflagefläche.

Abbildung 14: Messung der Brillanz ohne wellenlängenselektive Schicht bei schwarzer Auflagefläche.

**Erfindungsgemäße Beispiele**

In verschiedenen Messungen wurden unterschiedliche dekorative Schmuckelemente untersucht. Die dekorativen Schmuckelemente waren aus einem transparenten Schmuckelement, einer wellenlängenselektiven Schicht und einer farblich veränderbaren Auflagefläche aufgebaut. Die wellenlängenselektive Schicht wurde als wellenlängenselektive PVD-Beschichtung (vide supra) ausgeführt. Als farblich veränderbare Auflagefläche wurde für die Messungen aus Gründen der Praktikabilität schwarze bzw. weiße Folie verwendet. Die Folien entsprechen in ihren optischen Eigenschaften einem E-Paper und ermöglichten einen kleinen kompakten Messaufbau. Als weiße Folie wurde das Produkt 303/W und als schwarze Folie der Artikel 303/B der Firma Coroplast verwendet.

Als transparenter Schmuckstein wurde bei allen Messungen der transparente kreisrunde facettierte Flatback-Schmuckstein Chessboard-Circle (Art.Nr. 2035 mit 14mm Durchmesser) der Firma Swarovski verwendet.

Die Schmucksteine wurden mittels PVD-Verfahren mit der kubischen Beschichtungsanlage (Balzers BAK760) bedampft, siehe Position C in Abbildung 1. Die Schichtmaterialien wurden mittels Elektronenstrahlverdampfer verdampft. Die Abscheidung auf der Schmucksteinoberfläche wurde durch beschleunigte Sauerstoffionen aus einer Ionenquelle des Typs Veeco Mark II unterstützt.

Die wellenlängenselektive PVD-Beschichtung wies eine ausreichende UV-Transparenz auf, die eine Härtung des Klebstoffs ermöglichte Ein PVD-beschichteter Chessboard-Circle Schmuckstein wurde mit einem handelsüblichen transparenten UV-härtenden Klebstoff auf der weißen und ein zweiter gleich beschichteter Chessboard-Circle Schmuckstein auf der schwarzen Folie, siehe Position D der Abbildung 1, appliziert.

Als wellenlängenselektive PVD-Beschichtung wurde die in Tabelle 1 (vide infra) angeführte Beschichtungsvariante 1 gewählt, um ein Beispiel für Farben mit hoher Sättigung zu haben. Bei annähernd senkrechter Betrachtung ergibt sich bei weißer Auflagefläche die Farbe Magenta und bei schwarzer Auflagefläche die Farbe Grün.

Als weiteres Beispiel wurde Beschichtungsvariante 2 von Tabelle 2 (vide infra) gewählt. Bei annähernd senkrechter Betrachtung erhält man bei weißer Auflagefläche Gelb und bei schwarzer Auflagefläche Blau.

Bei den Brillanz-Messungen wurden als Vergleichsbeispiele Chessboard-Circle-Schmucksteine ohne wellenlängenselektive Schicht verwendet, um die Bedeutung der Schicht für die Brillanz nachzuweisen. Dabei wurden die transparenten Chessboard-Circle-Schmucksteine mit dem UVaushärtenden Klebstoff direkt auf die weiße und die schwarze Folie appliziert.

Tabelle 1: Beschichtungsvariante 1 für die Farben Magenta und Grün; Farben bei annähernd senkrechter Betrachtung.

| Schicht # | Material | Schichtdicke [nm] |
|-----------|----------|-------------------|
| 1 | $TiO_2$ | 143 |
| 2 | $SiO_2$ | 100 |
| 3 | $TiO_2$ | 69 |
| 4 | $SiO_2$ | 30 |
| 5 | $TiO_2$ | 59 |
| 6 | $SiO_2$ | 117 |
| 7 | $TiO_2$ | 28 |
| 8 | $SiO_2$ | 129 |
| 9 | $TiO_2$ | 26 |
| 10 | $SiO_2$ | 129 |
| 11 | $TiO_2$ | 21 |
| 12 | $SiO_2$ | 136 |
| 13 | $TiO_2$ | 27 |
| 14 | $SiO_2$ | 127 |
| 15 | $TiO_2$ | 133 |
| 16 | $SiO_2$ | 65 |

Tabelle 2: Beschichtungsvariante 2 für die Farben Gelb und Blau; Farben bei annähernd senkrechter Betrachtung.

| Schicht # | Material | Schichtdicke [nm] |
|-----------|----------|-------------------|
| 1 | $TiO_2$ | 43,8 |

(fortgesetzt)

| Schicht # | Material | Schichtdicke [nm] |
|---|---|---|
| 2 | $SiO_2$ | 38,1 |
| 3 | $TiO_2$ | 65,2 |
| 4 | $SiO_2$ | 52 |
| 5 | $TiO_2$ | 50 |
| 6 | $SiO_2$ | 83,8 |
| 7 | $TiO_2$ | 41,6 |
| 8 | $SiO_2$ | 89,2 |
| 9 | $TiO_2$ | 39,8 |
| 10 | $SiO_2$ | 89,6 |
| 11 | $TiO_2$ | 55,1 |
| 12 | $SiO_2$ | 39,1 |
| 13 | $TiO_2$ | 67 |
| 14 | $SiO_2$ | 138,5 |

**Messaufbauten**

Messung des Farbortes

Für die Messung des Farbortes wurde der L\*a\*b\* Farbraum gemäß DIN EN ISO 11664-4 verwendet, und für die Berechnung des Farbwechsels wurde der Farbabstand ∆E berechnet (vide supra).

Der Messaufbau ist in Abbildung 9 dargestellt. Als Lichtquelle wurde eine halbkugelförmige annähernd diffuse Beleuchtung gewählt und für die Erfassung des Farbortes eine digitale Messkamera. Eine diffuse Beleuchtung hat den Vorteil, dass es keine Vorzugsrichtung gibt. Das dekorative Schmuckelement wurde indirekt beleuchtet, indem eine ringförmige Lichtquelle (4) in Abbildung 9, nur in Richtung der Halbkugel (3) einen Lichtaustritt aufwies. Durch die Reflexionen an der Halbkugel erfolgte die Beleuchtung des dekorativen Schmuckelementes. Die Beleuchtung war jedoch nur annähernd diffus, da für die Messung mit der Kamera eine Öffnung (5) der Halbkugel (3) notwendig war. Die Halbkugel (3) in Abbildung 9 war aus Kunststoff gefertigt, hatte einen Durchmesser (6) von 300 mm und war an der inneren Oberfläche mit einer weißen Farbe versehen (matter Acryllack vom Typ RAL9010M). Als Lichtquelle (4) wurde eine ringförmige Lichtquelle vom Typ Osram L32W/25C Universal-Weiß verwendet. Durch diesen Aufbau erreichte man annähernd diffuse Lichtverhältnisse. Die Halbkugel (3) hatte zur Erfassung des Farbortes einen Öffnungsbereich (5) von 2x15°. Als Messkamera (2) wurde im Abstand (7) von 200 mm von der Mitte der Halbkugel zur Frontlinse der Kamera eine Kamera des Typs Canon EOS400D verwendet. Das dekorative Schmuckelement (1) wurde ca. 12 mm horizontal versetzt von der Mitte der Halbkugel platziert. Dies simuliert einen "geneigten Blickwinkel" auf das dekorative Schmuckelement, wie dies häufig bei visueller Betrachtung von Schmuckelementen der Fall ist. Die Richtung der horizontalen Versetzung ist beliebig, da die Beleuchtung ausreichend diffus ist.

Messung der Brillanz

Das dekorative Schmuckelement ist auch bei Farbwechsel brillant (vide supra). Um zu zeigen, wie wichtig der Aufbau des dekorativen Schmuckelementes für die Brillanz ist, wurden Brillanz-Messungen mit und ohne wellenlängenselektiver Beschichtung durchgeführt. Die Messungen erfolgten in einem abgedunkelten Raum, um keine weiteren störenden Lichteinflüsse zu haben.

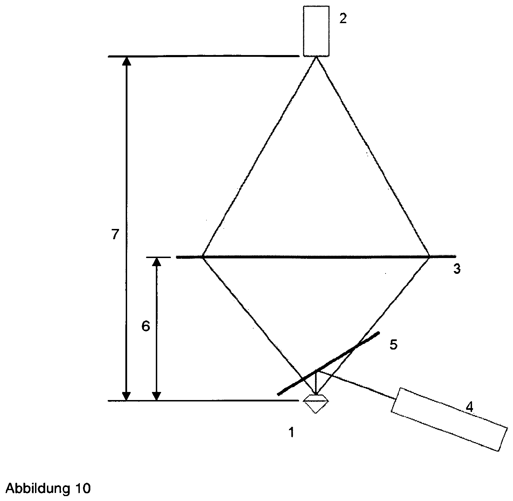

Der Messaufbau ist in Abbildung 10 dargestellt. Das dekorative Schmuckelement (1) wurde über den halbdurchlässigen Spiegel (5), den Plate Beamsplitter #46-583 der Firma Edmund Optics, mit einer annähernd kollimierten Lichtquelle (4) mit 2 x 0,25° Strahlaufweitung beleuchtet. Die annähernd kollimierte Lichtquelle wurde mit einem handelsüblichen fokussierbaren weißen LED-Lichtprojektor verwirklicht.

Das vom Schmuckelement reflektierte Licht wurde in 300 mm Entfernung (6) auf dem Streuschirm (3) aufgefangen. Der Streuschirm (3) hatte eine Größe von 600x600 mm$^2$ und war eine handelsübliche Diffusorfolie, die Luminit Light Shaping Diffuser 60°. Im Abstand (7) von 1500 mm von Schmuckelement zu Messkamera wurde eine Messkamera vom Typ AVT Manta G-235C mit 12 mm Objektiv angebracht, um die Verteilung des reflektierten Lichtes zu messen

Es wurden folgende Messungen durchgeführt:

V1: Erfindungsgemäßes Beispiel: Messung des Farbortes bei weißer und schwarzer Auflagefläche mit Beschichtungsvariante 1

V2: Erfindungsgemäßes Beispiel: Messung des Farbortes bei weißer und schwarzer Auflagefläche mit Beschichtungsvariante 2

V3: Erfindungsgemäßes Beispiel: Messung der Brillanz durch Messung der Verteilung des reflektierten Lichtes des dekorativen Schmuckelementes bei weißer und schwarzer Auflagefläche mit Beschichtungsvariante 2

V4: Vergleichsbeispiel: Messung der Brillanz durch Messung der Verteilung des reflektierten Lichtes des dekorativen Schmuckelementes bei weißer und schwarzer Auflagefläche ohne wellenlängenselektive Schicht

Ergebnis der Messungen:

V1:

Die Messung V1 des Farbortes mit Beschichtungsvariante-1-Schmucksteinen bei weißer und schwarzer Auflagefläche ergab:

schwarze Auflagefläche: L* = 71,4 / a* = -73,4 / b* = 14,5
weiße Auflagefläche: L* = 39,4 / a* = 63,5 / b* = 67,6
Der Farbabstand zwischen schwarzer und weißer Auflagefläche betrug ΔE = 160.6.

V2:

Die Messung V2 des Farbortes mit Beschichtungsvariante-2-Schmucksteinen bei weißer und schwarzer Auflagefläche ergab:

schwarze Auflagefläche: L* = 71,2 / a* = -18,8 / b* = -68,3
weiße Auflagefläche: L* = 58,9 / a* = 57,9 / b* = 67,2
Der Farbabstand zwischen schwarzer und weißer Auflagefläche betrug ΔE = 156,2.

V3:

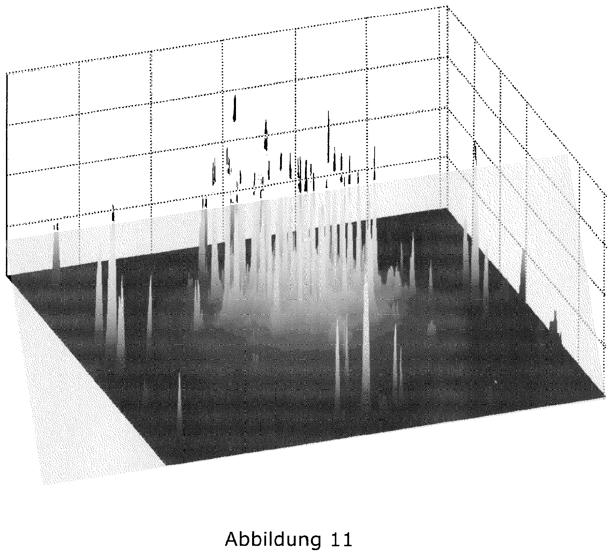

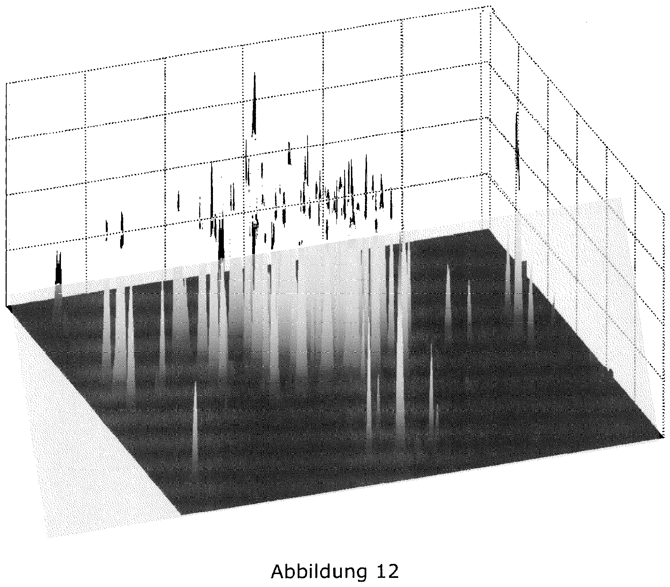

Die Messung der Brillanz mit Schmucksteinen der Beschichtungsvariante-2 bei weißer Auflagefläche ergab die Verteilung der Abbildung 11. Die Verteilung hat viele und ausgeprägte Reflexionslichtpunkte.
Für eine schwarze Auflagefläche erhielt man die Verteilung der Abbildung 12. Diese Verteilung hat ebenfalls viele und ausgeprägte Reflexionslichtpunkte.

V4:

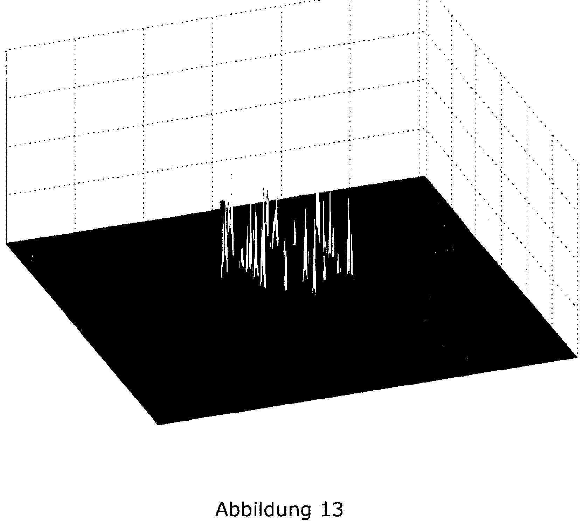

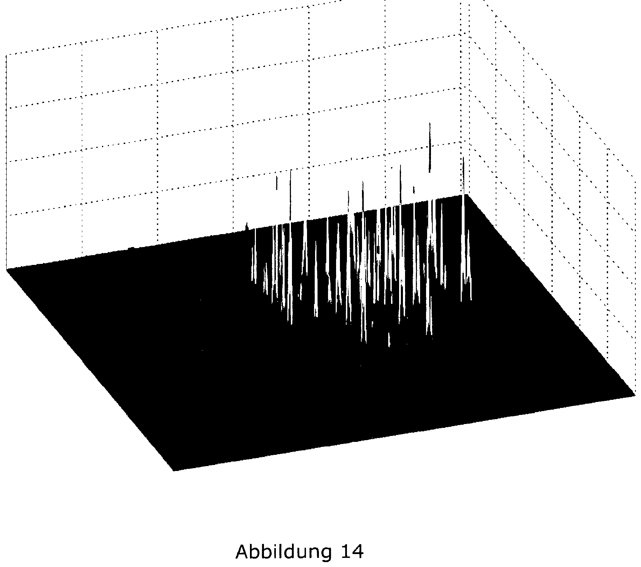

Die Messung der Brillanz wurde bei weißer und schwarzer Auflagefläche auch ohne wellenlängenselektive Schicht durchgeführt. Ohne wellenlängenselektive Schicht reduzierte sich bei weißer Auflagefläche die Reflexion signifikant, wie man Abbildung 13 entnehmen kann.
Das Gleiche gilt bei schwarzer Auflagefläche. In Abbildung 14 sieht man deutlich die reduzierte Reflexion des Lichtes.

Diskussion der Messergebnisse:

Aus den Messungen V1 und V2 ist ersichtlich, dass die Farbänderung der Auflagefläche von Schwarz auf Weiß zu deutlichen Farbänderungen des dekorativen Schmuckelementes führt. Die Farbe des dekorativen Schmuckelementes lässt sich durch den Schmuckstein, den Aufbau der wellenlängenselektiven Schicht und die Farbe der Auflagefläche beeinflussen.
Die Messungen V3 und V4 zeigen deutlich, dass die wellenlängenselektive Schicht wesentlich für das optische Erscheinungsbild ist, insbesondere für die Brillanz. Sowohl bei weißer als auch bei schwarzer Auflagefläche erhält man mit der wellenlängenselektiven Beschichtung, siehe Abbildung 11 und 12, breit verteilte und ausgeprägte Reflexionslichtpunkte, die einer hohen Brillanz (vide supra) entsprechen. Ohne wellenlängenselektive Beschichtung (Abbildungen 13 und 14) sind nur noch wenige und schwach ausgeprägte Reflexionslichtpunkte vorhanden, die einer niedrigen Brillanz entsprechen.

**Patentansprüche**

1. Farblich veränderbares Schmuckelement (A), enthaltend

   a. einen transparenten Schmuckstein mit plankonvexer Geometrie (B), **gekennzeichnet durch**
   b. eine farblich veränderbare Auflagefläche (D), und
   c. eine wellenlängenselektive Schicht (C), die zwischen dem transparenten Schmuckstein (B) und der farblich veränderbaren Auflagefläche (D) angeordnet ist.

2. Farblich veränderbares Schmuckelement nach Anspruch 1, **dadurch gekennzeichnet, dass** der transparente Schmuckstein (B) aus Glas oder Kunststoff gefertigt ist.

3. Farblich veränderbares Schmuckelement nach Anspruch 1 oder 2, **dadurch gekennzeichnet, dass** der transparente Schmuckstein (B) facettiert ist.

4. Farblich veränderbares Schmuckelement nach Anspruch 3, **dadurch gekennzeichnet, dass** der Neigungswinkel α der ersten Facette zur Grundfläche des transparenten Schmucksteins (B) im Winkelbereich von 10° bis 40° liegt.

5. Farblich veränderbares Schmuckelement nach Anspruch 3 oder 4, **dadurch gekennzeichnet, dass** die wellenlängenselektive Schicht (C) auf der

   a) der facettierten Seite gegenüberliegenden planen Seite am Schmuckstein (B) aufgebracht ist oder
   b) auf der Auflagefläche (D) aufgebracht ist.

6. Farblich veränderbares Schmuckelement nach wenigstens einem der vorhergehenden Ansprüche, **dadurch gekennzeichnet, dass** die wellenlängenselektive Schicht (C) aus einer wellenlängenselektiven Beschichtung oder einer wellenlängenselektiven Folie gefertigt ist.

**7.** Farblich veränderbares Schmuckelement nach Anspruch 6, **dadurch gekennzeichnet, dass** die wellenlängenselektive Beschichtung (C) wenigstens ein Metall und/oder eine Metallverbindung enthält, vorzugsweise mit einem Aufbau, der eine Abfolge von $SiO_2$ - und $TiO_2$-Schichten umfasst.

**8.** Farblich veränderbares Schmuckelement nach wenigstens einem der vorhergehenden Ansprüche, **dadurch gekennzeichnet, dass** die wellenlängenselektive Schicht (C) im Wellenlängenbereich von 380 - 780 nm reflektiert und transmittiert.

**9.** Farblich veränderbares Schmuckelement nach Anspruch 8, **dadurch gekennzeichnet, dass** die wellenlängenselektive Schicht (C) zusätzlich im Wellenlängenbereich von 360 - 420 nm mindestens 20% transmittiert.

**10.** Farblich veränderbares Schmuckelement nach Anspruch 8 oder 9, **dadurch gekennzeichnet, dass** die wellenlängenselektive Schicht (C) im Wellenlängenbereich von 400 bis 700 nm einen gemittelten Reflexionsgrad von weniger als 75% hat.

**11.** Farblich veränderbares Schmuckelement nach wenigstens einem der vorhergehenden Ansprüche, **dadurch gekennzeichnet, dass** als Auflagefläche (D) ein elektronisch schaltbares Display verwendet wird.

**12.** Farblich veränderbares Schmuckelement nach Anspruch 11, **dadurch gekennzeichnet, dass** das elektronisch schaltbare Display zwischen schwarzer und weißer Farbe umschaltet.

**13.** Farblich veränderbares Schmuckelement nach wenigstens einem der vorhergehenden Ansprüche, **dadurch gekennzeichnet, dass** die Komponenten a) - c) des dekorativen Schmuckelementes durch einen Klebstoff verbunden sind.

**14.** Verfahren zum Verändern der Farbe eines farblich veränderbaren Schmuckelementes nach wenigstens einem der vorhergehenden Ansprüche, **dadurch gekennzeichnet, dass** man die Farbe der Auflagefläche (D) mittels einer elektronischen Schaltung wechselt.

**Claims**

**1.** Colour-changeable ornamental element (A) containing

    a. a transparent gemstone which has a plano-convex geometry (B), **characterised by**
    b. a colour-changeable support surface (D), and
    c. a wavelength-selective layer (C) which is arranged between the transparent gemstone (B) and the colour-changeable support surface (D).

**2.** Colour-changeable ornamental element according to claim 1, **characterised in that** the transparent gemstone (B) is made of glass or plastics material.

**3.** Colour-changeable ornamental element according to either claim 1 or claim 2, **characterised in that** the transparent gemstone (B) is faceted.

**4.** Colour-changeable ornamental element according to claim 3, **characterised in that** the angle of inclination $\alpha$ of the first facet with respect to the base surface of the transparent gemstone (B) is within the angular range of from 10° to 40°.

**5.** Colour-changeable ornamental element according to either claim 3 or claim 4, **characterised in that** the wavelength-selective layer (C) is applied to

    a) the gemstone (B) on the planar face opposite the faceted face or
    b) the support surface (D).

**6.** Colour-changeable ornamental element according to at least one of the preceding claims, **characterised in that** the wavelength-selective layer (C) is made from a wavelength-selective coating or a wavelength-selective film.

**7.** Colour-changeable ornamental element according to claim 6, **characterised in that** the wavelength-selective coating (C) contains at least one metal and/or a metal compound, preferably having a structure which comprises a sequence of $SiO_2$ and $TiO_2$ layers.

**8.** Colour-changeable ornamental element according to at least one of the preceding claims, **characterised in that** the wavelength-selective layer (C) reflects and transmits in the wavelength range of 380 - 780 nm.

**9.** Colour-changeable ornamental element according to claim 8, **characterised in that** the wavelength-selective layer (C) additionally transmits at least 20% in the wavelength range of 360 - 420 nm.

**10.** Colour-changeable ornamental element according to either claim 8 or claim 9, **characterised in that** the wavelength-selective layer (C) has an average reflectance of less than 75% in the wavelength range of 400 to 700 nm.

**11.** Colour-changeable ornamental element according to at least one of the preceding claims, **characterised in that** an electronically switchable display is used as the support surface (D).

12. Colour-changeable ornamental element according to claim 11, **characterised in that** the electronically switchable display switches between black and white colour.

13. Colour-changeable ornamental element according to at least one of the preceding claims, **characterised in that** components a) - c) of the decorative ornamental element are connected by an adhesive.

14. Method for changing the colour of a colour-changeable ornamental element according to at least one of the preceding claims, **characterised in that** the colour of the support surface (D) is changed by means of an electronic circuit.

**Revendications**

1. Élément décoratif à couleur modifiable (A), contenant

   a. une pierre décorative (B) transparente à géométrie plane-convexe, **caractérisé par**
   b. une surface de support (D) à couleur modifiable, et
   c. une couche sélective en longueur d'onde (C), laquelle est disposée entre la pierre décorative (B) transparente et la surface de support (D) à couleur modifiable.

2. Élément décoratif à couleur modifiable selon la revendication 1, **caractérisé en ce que** la pierre décorative (B) transparente est en verre ou en matière plastique.

3. Élément décoratif à couleur modifiable selon la revendication 1 ou 2, **caractérisé en ce que** la pierre décorative (B) transparente est facettée.

4. Élément décoratif à couleur modifiable selon la revendication 3, **caractérisé en ce que** l'angle d'inclinaison $\alpha$ de la première facette par rapport à la surface de base de la pierre décorative (B) transparente se situe dans la plage angulaire de 10° à 40°.

5. Élément décoratif à couleur modifiable selon la revendication 3 ou 4, **caractérisé en ce que** la couche sélective en longueur d'onde (C) est

   a) appliquée sur la face plane opposée à la face facettée sur la pierre décorative (B) ou
   b) appliquée sur la surface de support (D).

6. Élément décoratif à couleur modifiable selon au moins l'une des revendications précédentes, **carac-**

**térisé en ce que** la couche sélective en longueur d'onde (C) est constituée d'un revêtement sélectif en longueur d'onde ou d'un film sélectif en longueur d'onde.

7. Élément décoratif à couleur modifiable selon la revendication 6, **caractérisé en ce que** le revêtement sélectif en longueur d'onde (C) contient au moins un métal et/ou un composé métallique, de préférence comportant une structure qui comprend une séquence de couches de $SiO_2$ et $TiO_2$.

8. Élément décoratif à couleur modifiable selon au moins l'une des revendications précédentes, **caractérisé en ce que** la couche sélective en longueur d'onde (C) réfléchit et transmet dans la plage de longueurs d'onde de 380 à 780 nm.

9. Élément décoratif à couleur modifiable selon la revendication 8, **caractérisé en ce que** la couche sélective en longueur d'onde (C) transmet en plus au moins 20 % dans la plage de longueurs d'onde de 360 à 420 nm.

10. Élément décoratif à couleur modifiable selon la revendication 8 ou 9, **caractérisé en ce que** la couche sélective en longueur d'onde (C) présente une réflectance moyenne inférieure à 75 % dans la plage de longueurs d'onde de 400 à 700 nm.

11. Élément décoratif à couleur modifiable selon au moins l'une des revendications précédentes, **caractérisé en ce qu'**un affichage commutable électroniquement est utilisé comme surface de support (D).

12. Élément décoratif à couleur modifiable selon la revendication 11, **caractérisé en ce que** l'affichage commutable électroniquement commute entre la couleur noire et la couleur blanche.

13. Élément décoratif à couleur modifiable selon au moins l'une des revendications précédentes, **caractérisé en ce que** les composants a) à c) de l'élément décoratif sont reliés par un adhésif.

14. Procédé permettant de changer la couleur d'un élément décoratif à couleur modifiable selon au moins l'une des revendications précédentes, **caractérisé en ce que** la couleur de la surface de support (D) est modifiée au moyen d'un circuit électronique.

A {

B

C

D

Abbildung 1

α

Abbildung 2

α

β

RB

Abbildung 3

Abbildung 4

Abbildung 5

Abbildung 6

Abbildung 7

Abbildung 8

Abbildung 9

Abbildung 10

Abbildung 11

Abbildung 12

Abbildung 13

Abbildung 14

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1086269 B1
- US 201201133676 A1
- CN 201700538 U
- GB 798080 A
- US 20070274160 A1